# EUROPEAN PATENT SPECIFICATION

(11) **EP 4 532 972 B1**
(45) Date of publication and mention of the grant of the patent: **22.10.2025**
(21) Application number: 23728366.8
(22) Date of filing: 24.05.2023
(51) Int. Cl.: F21K 9/232, F21K 9/64, H01L 25/075

(54) **A LED LIGHT SOURCE FILAMENT ARRANGEMENT COMPRISING BLUE AND RED LEDS**
LED-LICHTQUELLEN-GLÜHFADEN-ANORDNUNG, DIE BLAUE UND ROTE LEDS UMFASST
AGENCEMENT DE FILAMENT DE SOURCE LUMINEUSE À DEL COMPRENANT DES DEL BLEUES ET ROUGES

(30) Priority: 02.06.2022 EP 22177007
(43) Date of publication of application: 09.04.2025
(73) Proprietor: Signify Holding B.V., 5656 AE Eindhoven (NL)
(72) Inventor: VAN BOMMEL, Ties, 5656 AE Eindhoven (NL); HIKMET, Rifat, Ata, Mustafa, 5656 AE Eindhoven (NL)
(74) Representative: Verweij, Petronella Daniëlle
(86) International application number: PCT/EP2023/063937
(87) International publication number: WO 2023/232594

(56) References cited:
- WO-A1-2020/002144
- WO-A1-2021/073930
- US-B1- 10 026 874

## Description

### FIELD OF THE INVENTION

The invention relates to a LED light source filament arrangement configured to, in operation, emit LED filament light, the LED light source filament arrangement comprising a first plurality of LED light sources configured to, in operation, emit first LED light source light, the first LED light source light comprising blue LED light source light, a second plurality of LED light sources configured to, in operation, emit second LED light source light, the second LED light source light comprising red LED light source light, and a luminescent layer covering the first plurality of LED light sources and the second plurality of LED light sources.

### BACKGROUND OF THE INVENTION

New lighting efficiency energy labelling regulations has been made. According to these regulations, LED lamps previously rated as A++ are now moved to an E rating. Only the most energy efficient light bulbs can be rated A class. Therefore, there is an increased desire for providing more energy labelling regulations.

The dominant architecture in lamps is LED filament lamps. An LED filament lamp is an LED lamp which is designed to resemble a traditional incandescent light bulb with a visible filament for aesthetic and light distribution purposes, but with the high efficiency of light-emitting diodes.

Remote phosphor, which is the optimal efficient LED architecture, can be applied on the envelope (light exit window) of a LED filament lamp. However, due to conversion of LED filament light, the filament is not visible anymore.

EP 2 535 640 A1 discloses a LED source light bulb, comprising: a LED source light bulb shell; a core column with an exhaust tube and a bracket; at least one LED light source light emitting strip with LED chips therein emitting 4π light; a driver; and an electrical connector, wherein the LED light source light bulb shell is vacuum sealed with the core column so as to form a vacuum sealed chamber, which is filled with a gas having a low coefficient of viscosity and a high coefficient of thermal conductivity, the bracket and the LED light source light emitting strips fixed on the bracket are housed in the vacuum sealed chamber, the LED light source light emitting strip is in turn electrically connected to the driver, the electrical connector, while the electrical connector is used to be electrically connected to an external power supply, so as to light the LED light source light emitting strips. Also disclosed is providing the LED light source light emitting strips with LED chips emitting 4π light, as used in the LED light source light bulb.

WO 2021/073930 A1 discloses a LED filament lamp comprising at least one LED filament having a base portion and a top portion extending over a length, L, along a longitudinal axis, A, wherein the LED filament comprises an array of a plurality of light emitting diodes, LEDs, extending along the longitudinal axis A. An encapsulant at least partially enclosing the plurality of LEDs, wherein the encapsulant comprises a luminescent material. The linear array of LEDs comprising a plurality of blue LEDs emitting blue light and a plurality of red LEDs emitting red light, whereby these LEDs are distributed such that the color temperature, CTL, of the light emitted from the at least one LED filament decreases from the base portion to the top portion over at least a portion of the length of the at least one LED filament.

It is thus desired to provide a more energy efficient LED light source light source exploiting the possibilities of applying a luminescent layer, and with which the LED light source filament remains visible.

### SUMMARY OF THE INVENTION

It is an object of the present invention to overcome this problem, and to provide a more energy efficient LED light source filament arrangement exploiting the possibilities of applying a luminescent layer, and with which the LED light source filament remains visible.

According to a first aspect of the invention, this and other objects are achieved by means of a LED light source filament arrangement configured to, in operation, emit LED filament light, the LED light source filament arrangement comprising a first plurality of LED light sources configured to, in operation, emit first LED light source light, the first LED light source light comprising blue LED light source light, a second plurality of LED light sources configured to, in operation, emit second LED light source light, the second LED light source light comprising red LED light source light, and a luminescent layer covering at least a part of the first plurality of LED light sources and at least a part of the second plurality of LED light sources, the luminescent layer being configured to convert at least 88% of the blue LED light source light into converted light, the converted light being any one or more of green and yellow light, and the second plurality of LED light sources being arranged in a successional configuration without any LED light sources configured to, in operation, emit LED light source light of other colors than red being provided in the succession of the LED light sources of the second plurality of LED light sources.

In other words, the second plurality of LED light sources is arranged in a configuration comprising only the second plurality of LED light sources. Thereby, and especially by providing that the luminescent layer is configured to convert at least 90% of the blue LED light source light into converted light, the converted light being green-yellow light, and that the second plurality of LED light sources is arranged in a successional configuration without any LED light sources configured to, in operation, emit LED light source light of other colors than red being provided in the succession of the LED light sources of the second plurality of LED light sources, a LED light source filament arrangement is provided which is more energy efficient, with which the possibilities of applying a luminescent layer is exploited, and with which the LED light source filament remains visible.

In embodiments, the luminescent layer is configured to convert at least 89%, at least 90%, or even at least 91% of the blue LED light source light into converted light. Best conversion percentage slightly depends on green/yellow phosphor used.

For the most suitable green/yellow phosphor, e.g. YAG, the luminescent layer converts at least 90% of the blue LED light source light into converted light. Thereby, the blue LED light source light is not (or only slightly at a short distance) visible. Especially at least 90% even at a short distance no blue LED light source light is visible.

In embodiments, the luminescent layer is configured to convert ≤96% of the blue LED light source light into converted light, preferably ≤95%, more preferably ≤94%, most preferably ≤93%.

Thereby an improved light quality is obtained. The reason is that still a very small fraction of blue light is present in the LED filament light. Otherwise only of black body locus LED filament light can be achieved.

In embodiments, the luminescent layer is configured to convert 90% to 94% of the blue LED light source light into converted light.

In an embodiment, the first plurality of LED light sources and the second plurality of LED light sources are arranged on the same carrier. The carrier may be a printed circuit board (PCB).

Thereby, a LED light source filament arrangement with a simple structure is provided for.

In an alternative embodiment, the first plurality of LED light sources may be arranged on a first carrier, such as a PCB, and the second plurality of LED light sources may be arranged on a second carrier, such as a PCB.

Thereby, a LED light source filament arrangement is provided with which the first plurality of LED light sources and the second plurality of LED light sources may be kept separated in a structurally particularly simple manner.

According to the invention, the second plurality of LED light sources further comprises a plurality of LED light sources configured to, in operation, emit blue LED light source light, such that the second LED light source light further comprises blue LED light source light, the said plurality of LED light sources configured to, in operation, emit red LED light source light being covered by a second phosphor converting the blue LED light source light into red LED light source light.

By providing a phosphor applied to the first plurality of LED light sources, the first plurality of LED light sources pump the phosphor and are thereby made invisible. By providing a phosphor applied to the second plurality of LED light sources, the visibility of the second plurality of LED light sources is improved considerably. Generally, this provides for a LED light source filament arrangement with which the visibility of the second plurality of LED light sources is improved considerably.

In an embodiment, the luminescent layer is provided in a distance from at least one of the first plurality of LED light sources and the second plurality of LED light sources.

Thereby, a LED light source filament arrangement is provided with which most or even any spottiness of the first plurality of LED light sources may be avoided, especially when the LED light source filament arrangement is perceived from a close distance, thus providing a particularly uniform light output.

In an embodiment, the distance between the luminescent layer and the first plurality of LED light sources and the second plurality of LED light sources is more than 5 mm, preferably at least 8 mm, more preferably at least 10 mm, most preferably at least 12 mm. The larger the distance the higher the efficiency of the LED filament arrangement.

Thereby, an optimal tradeoff between compactness of the LED light source filament arrangement and sufficient avoidance of spottiness is obtained.

In an embodiment, a pitch P2 of the second plurality of LED light sources is smaller than a pitch P1 of the first plurality of LED light sources. In embodiments, P2 ≤ 0.7*P1, especially P2 ≤ 0.5*P1. In alternative embodiments, P2 ≤ 0.2*P1, P2 ≤ 0.4*P1, P2 ≤ 0.6*P1, P2 ≤ 0.8*P1 or P2 ≤ 0.9*P1.

Thereby a LED light source filament arrangement is provided with which the uniform appearance of the filament is improved.

In an embodiment, the LED filament light comprises a correlated color temperature (CCT) being smaller than 2700 K, preferably smaller than 2500 K, more preferably smaller than 2450 K, most preferably smaller than 2400 K such as 2200 K or 2100 K.

In an embodiment, the LED filament light may white light, preferably having a color rendering index of at least 80.

Since the second plurality of LED light sources are best visible at low CCTs because of the high red content in the extreme warm white spectrum, this provides for a LED light source filament arrangement with which the visibility of the second plurality of LED light sources is improved even further.

In an embodiment, the LED filament light comprises a correlated color temperature (CCT) being smaller than 2250 K.

Thereby, a LED light source filament arrangement is provided with which the visibility of the second plurality of LED light sources is improved still further.

In an embodiment, the LED filament light comprises a color rendering index (CRI) being larger than 80.

Thereby, a LED light source filament arrangement with an additional improvement of the visibility of the second plurality of LED light sources is obtained.

In an embodiment, the luminescent layer is configured to convert less than 5%, less than 3 %, less than 2 %, less than 1 % or 0 % of the red LED light source light into converted light.

Thereby, dilution or weakening of the red light is avoided and the viewer's perception of a filament is enhanced.

In an embodiment, the phosphor is configured to convert at least 75 % of the blue light.

Thereby, the LED filament light is provided with an overall higher CCT, which in turn provides for a more agreeable light as perceived by a viewer.

In an embodiment, the phosphor is configured to convert at least 90 % of the blue light.

Thereby, the LED filament light is provided with an overall even higher CCT, which in turn provides for an even more agreeable light as perceived by a viewer.

In an embodiment, the phosphor is configured to convert between 70 % and 97 %, of the blue light.

Conversion within such a percentage interval has been shown to provide the LED filament light with a CCT, which provides for a particularly agreeable light as perceived by a viewer.

In an embodiment, the second plurality of LED light sources are arranged on a continuous line, and the first plurality of LED light sources are distributed around said line.

Thereby, a LED light source filament arrangement is provided with which the light output to a particularly high degree visually resembles that of a filament.

In an embodiment, the line is arranged in a meandering or spiral pattern.

Thereby, it becomes possible to provide a LED light source filament arrangement which to a particularly high degree visually resembles more decorative filament patterns of various different types.

In an embodiment, the first plurality of LED light sources are arranged in a matrix.

Thereby, it becomes possible to provide a LED light source filament arrangement which to a particularly high degree visually resembles further different decorative filament patterns.

In an embodiment, the carrier comprises a shape being different from elongated, particularly a shape being different from highly elongated.

It is noted that the term highly elongated is intended to refer to carriers comprising a length being four or more the width of the carrier, or even five or more times the width of the carrier. Particularly, the carrier may comprise a length L and a width W fulfilling the relation 0.5 < L/W < 2.

Thereby, a LED light source filament arrangement is provided which may have other shapes than highly elongated while still having a high aspect ratio, because a red line is visible on the light emitting surface.

In an embodiment, the LED light source filament arrangement comprises a light exit window from which the LED filament light is emitted, and the second plurality of LED light sources are arranged closer to the light exit window than the first plurality of LED light sources.

Thereby, the visibility of the second plurality of LED light sources may be optimized even further, and the visual appearance of a filament may be emphasized further.

In an embodiment, the LED light source filament arrangement further comprises a controller for individually controlling the first plurality of LED light sources and the second plurality of LED light sources, the controller being configured to change the correlated color temperature of said LED filament light from a first correlated color temperature (CCT1) to a second correlated color temperature (CCT2), wherein ICCT1 - CCT21 ≥ 300K.

Since the second plurality of LED light sources are best visible at low CCTs because of the high red content in the extreme warm white spectrum, providing CCT control enables providing for a LED light source filament arrangement with which the visibility of the second plurality of LED light sources may be optimized continuously or with predetermined time intervals.

The present invention further concerns a LED light source filament arrangement configured to, in operation, emit LED filament light, the LED light source filament arrangement comprising a first plurality of LED light sources configured to, in operation, emit first LED light source light, the first LED light source light comprising blue LED light source light, a second plurality of LED light sources configured to, in operation, emit second LED light source light, the second LED light source light comprising red LED light source light, and a luminescent layer covering at least a part of the first plurality of LED light sources and at least a part of the second plurality of LED light sources, the luminescent layer is configured to convert part of the blue LED light source light into converted light, the converted light being one or more of green and yellow light, the LED filament light comprises 3%-7% blue LED light source light (with respect to the total power of the LED filament light), and the second plurality of LED light sources being arranged in a successional configuration without any LED light sources configured to, in operation, emit LED light source light of other colors than red being provided in the succession of the LED light sources of the second plurality of LED light sources.

The present invention further concerns a lamp or a luminaire comprising a LED light source filament arrangement according to the invention.

It is noted that the invention relates to all possible combinations of features recited in the claims.

### BRIEF DESCRIPTION OF THE DRAWINGS

This and other aspects of the present invention will now be described in more detail, with reference to the appended drawings showing embodiment(s) of the invention.
Fig. 1 shows a cross sectional side view of a LED light source filament arrangement according to an embodiment not claimed.
Fig. 2 shows a cross sectional side view of a LED light source filament arrangement according to another embodiment not claimed.
Fig. 3 shows a cross sectional side view of a LED light source filament arrangement according to another embodiment not claimed.
Fig. 4 shows a cross sectional side view of a LED light source filament arrangement according to an embodiment of the invention.
Fig. 5 shows a cross sectional side view of a LED light source filament arrangement according to another embodiment not claimed.
Fig. 6 shows a cross sectional side view of a LED light source filament arrangement according to another embodiment not claimed.
Fig. 7 shows a top view of a LED light source filament arrangement according to another embodiment of the invention.
Fig. 8 shows a top view of a LED light source filament arrangement according to another embodiment of the invention.
Fig. 9 shows the LED light source filament arrangement according to Fig. 8 as it will be perceived by a viewer when it is in an off-state.
Fig. 10 shows the LED light source filament arrangement according to Fig. 8 as it will be perceived by a viewer when it is in an on-state.
Figs. 11-13 show cross-sectional side views of a LED light source filament arrangement according to the invention illustrating the luminescent layer being arranged directly on the plurality of first LED light sources and the plurality of second LED light sources, proximate to the plurality of first LED light sources and the plurality of second LED light sources and in a distance from the plurality of first LED light sources and the plurality of second LED light sources, respectively.
Fig. 14 shows a cross sectional side view of a lamp comprising a LED light source filament arrangement according to the invention.

As illustrated in the figures, the sizes of layers and regions are exaggerated for illustrative purposes and, thus, are provided to illustrate the general structures of embodiments of the present invention. Like reference numerals refer to like elements throughout.

### DETAILED DESCRIPTION

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and fully convey the scope of the invention to the skilled person.

As used herein blue light is intended to refer to light with a wavelength in the range of 420 nm to 495 nm. As used herein green light is intended to refer to light with a wavelength in the range of 495 nm to 560 nm. As used herein yellow light is intended to refer to light with a wavelength in the range of 560 nm to 590 nm. As used herein orange light is intended to refer to light with a wavelength in the range of 590 nm to 615 nm. As used herein red light is intended to refer to light with a wavelength in the range of 615 nm to 720 nm.

As used herein, when stating that a plurality of LED light sources is configured to, in operation, emit LED light source light of a particular desired color, particularly red or blue, it is intended to encompass both that the plurality of LED light sources, in operation, emit LED light source light of the desired color directly and that the plurality of LED light sources, in operation, emit LED light source light of the desired color in virtue of comprising a light conversion layer or element converting the light actually emitted by the LED light sources into light of the desired color.

As used herein, "LED light sources" are intended to encompass one or more of laser diodes, LEDs, and super-luminescent diodes.

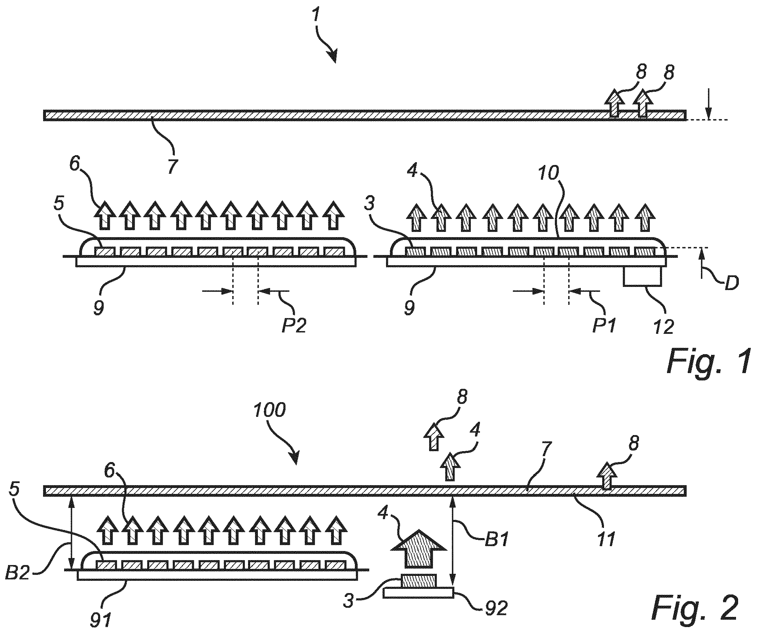

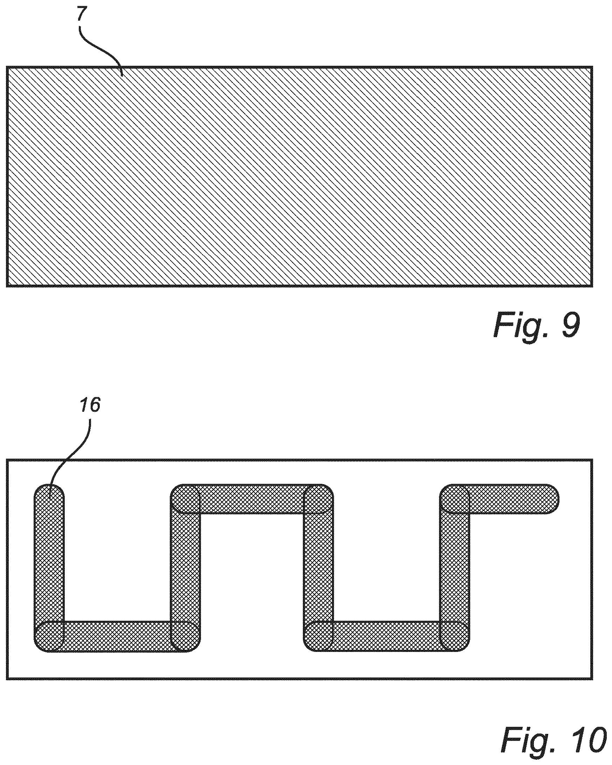

Fig. 1 shows a cross sectional side view of a LED light source filament arrangement 1 according to the invention. The LED light source filament arrangement 1 is configured to, in operation, emit LED light source filament light 2 (Fig. 9). Generally, and irrespective of the embodiment, the LED light source filament arrangement 1 comprises a first plurality of LED light sources 3 configured to, in operation, emit first LED light source light 4 (not shown on Fig. 1, cf. e.g. Fig. 2), the first LED light source light being or comprising blue LED light source light, a second plurality of LED light sources 5 configured to, in operation, emit second LED light source light 6, the second LED light source light being or comprising red LED light source light, and a luminescent layer 7 covering at least a part of the first plurality of LED light sources 3 and at least a part of the second plurality of LED light sources 5.

Generally, and irrespective of the embodiment, the luminescent layer 7 is configured to convert at least 90 % of the blue LED light source light 4 into converted light 8. The converted light 8 is one or more of green and yellow light. The LED light source filament light 2 thus comprises a combination of blue light 4, red light 6 and converted green and/or yellow light 8. In the embodiment shown on Fig. 1, the part of the luminescent layer 7 covering the second plurality of LED light sources 5, and the part of the luminescent layer 7 covering the first plurality of LED light sources 3 is identical. Alternatively, the part of the luminescent layer 7 covering the second plurality of LED light sources 5, and the part of the luminescent layer 7 covering the first plurality of LED light sources 3 may be mutually different.

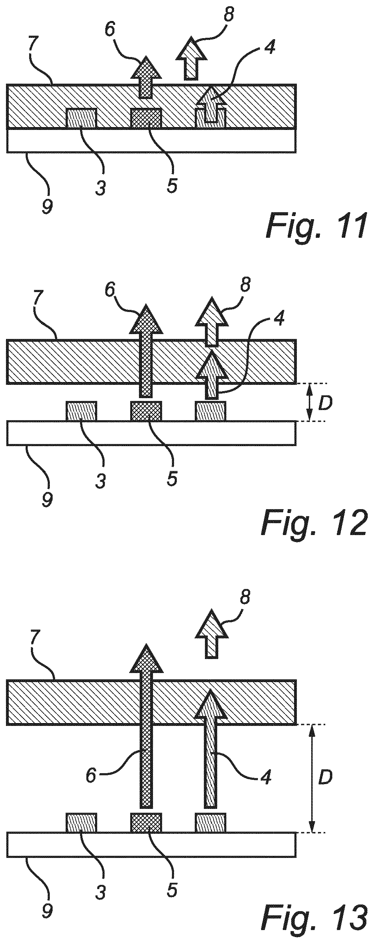

The luminescent layer 7 is provided in a distance D from the first plurality of LED light sources 3 and the second plurality of LED light sources 5. The distance may be 5 mm or more than 5 mm. The luminescent layer 7 may be provided in a proximity of the first plurality of LED light sources 3 and the second plurality of LED light sources 5 as shown in Fig. 12. Alternatively, the luminescent layer 7 may be provided in a larger distance from the first plurality of LED light sources 3 and the second plurality of LED light sources 5 as shown in Fig. 13. The luminescent layer 7 may also be applied directly on a surface of the first plurality of LED light sources 3 and the second plurality of LED light sources 5 as shown in Fig. 11. The luminescent layer 7 may be configured to convert the blue light 4 into green light, yellow light 8 or a combination thereof. The luminescent layer 7 is configured to convert at least 75 %, or at least 90 %, or between 70 % and 97 %, of the blue light 4.

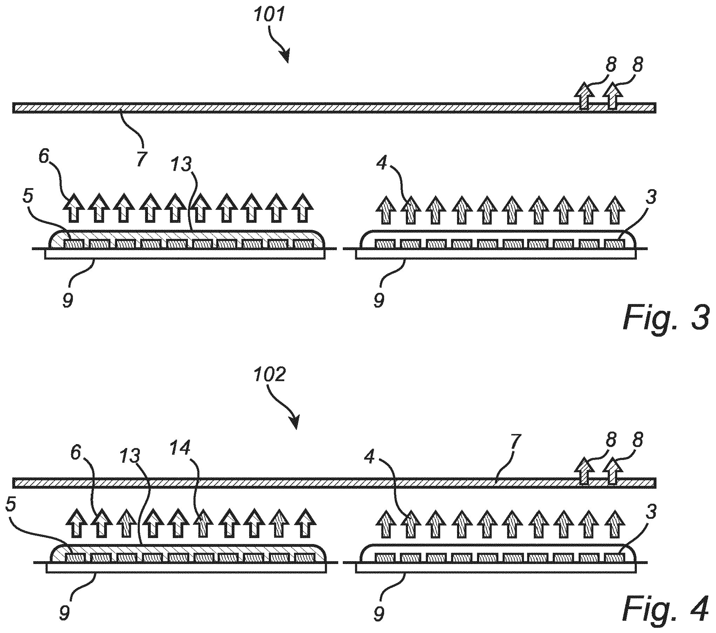

The LED light source filament arrangement 1 may further optionally comprise an envelope enclosing the first plurality of LED light sources 3 and/or the second plurality of LED light sources 5. The envelope may comprise or carry one or more of a phosphor 10 applied to the first plurality of LED light sources 3 and a phosphor 13 (Fig. 3) applied to the second plurality of LED light sources 5. The phosphor 13 is described further below in connection with Fig. 3. In the embodiment shown on Fig. 1 there is only applied a phosphor 10 on the envelope enclosing the first plurality of LED light sources 3.

The second plurality of LED light sources 5 are arranged without or free from any LED light sources configured to, in operation, emit LED light source light of other colors than red being provided between the LED light sources of the second plurality of LED light sources 5. The second plurality of LED light sources 5 are arranged in a succession configuration, such a row or a line, comprising only LED light sources of the second plurality of LED light sources 5.

The LED light source filament arrangement further comprises a carrier 9, such as a printed circuit board (PCB). The first plurality of LED light sources and the second plurality of LED light sources are in the embodiment shown on Fig. 1 arranged on the same carrier 9.

The first plurality of LED light sources 3 are arranged with a first pitch, or center to center distance, P1. The second plurality of LED light sources 5 are arranged with a second pitch, or center to center distance, P2. The pitch P2 of the second plurality of LED light sources 5 may be smaller than the pitch P1 of the first plurality of LED light sources 3. The pitch P2 of the second plurality of LED light sources 5 may also be the same as the pitch P1 of the first plurality of LED light sources 3. The LED light source filament arrangement 1 further comprises a light exit window 11 (Fig. 2) from which the LED light source filament light 2 is emitted.

The second plurality of LED light sources 5 are arranged in the same distance from the light exit window 11 as the first plurality of LED light sources 3. In other words, the first plurality of LED light sources 3 are arranged in a first distance B1 from the light exit window 11, the second plurality of LED light sources 5 are arranged in a second distance B2 from the light exit window 11, and B2 is equal to B1.

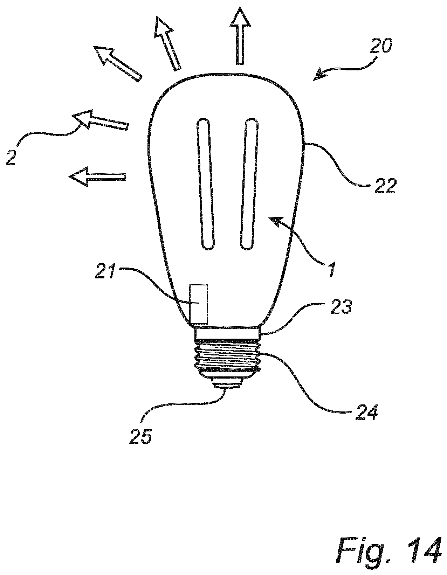

The LED light source filament arrangement light 2 (Fig. 14), or simply LED filament light, may comprise a correlated color temperature (CCT) being smaller than 2500 K or a correlated color temperature (CCT) being smaller than 2250 K. The LED light source filament arrangement light 2 may further comprise a color rendering index (CRI) being larger than 80.

The LED light source filament arrangement 1 may further optionally comprise a controller 12. The controller 12 is configured for individually controlling the first plurality of LED light sources and the second plurality of LED light sources, in particular such as to obtain CCT control. The controller 12 may also be configured for individually controlling the first plurality of LED light sources and the second plurality of LED light sources such as to obtain control of other parameters.

Fig. 2 shows a cross sectional side view of a LED light source filament arrangement 100 according to another embodiment of the invention. The LED light source filament arrangement 100 differs from that of Fig. 1 described above in virtue of the following features.

The first plurality of LED light sources 3 of the LED light source filament arrangement 100 are provided as ordinary LED light source chips. The first plurality of LED light sources 3 are therefore not provided on a filament. Rather, the first plurality of LED light sources 3 are arranged on a substrate 92 being different from or separate from the substrate 91 or filament on which the second plurality of LED light sources 5 are arranged.

The second plurality of LED light sources 5 are arranged closer to the light exit window 11 than the first plurality of LED light sources 3. In other words, the first plurality of LED light sources 3 are arranged in a first distance B1 from the light exit window 11, the second plurality of LED light sources 5 are arranged in a second distance B2 from the light exit window 11, and B2 is smaller than B1.

Fig. 3 shows a cross sectional side view of a LED light source filament arrangement 101 according to another embodiment of the invention. The LED light source filament arrangement 101 differs from that of Fig. 1 described above in virtue of the following features.

The LED light source filament arrangement 101 comprises a phosphor 13 applied to the second plurality of LED light sources 5. The phosphor 13 is configured to convert light emitted by the second plurality of LED light sources 5 into red light 6. Thus, the second plurality of LED light sources 5 need in this embodiment not necessarily emit first LED light source light being red light directly, i.e. be red LED light sources.

Also, in the embodiment shown on Fig. 3 there is not applied any phosphor 10 to the first plurality of LED light sources 3. In other embodiments there may, however, be applied both a phosphor 10 to the first plurality of LED light sources 3 and a phosphor 13 to the second plurality of LED light sources 5. The phosphor 13 may be provided in a distance from the second plurality of LED light sources 5. The distance may be more than 1 mm. The phosphor 13 may be provided in or as part of the luminescent layer 7, or as a coating on the luminescent layer 7. The phosphor 13 may also be provided directly on an envelope enclosing the second plurality of LED light sources 5 or directly on a surface of the second plurality of LED light sources 5.

Fig. 4 shows a cross sectional side view of a LED light source filament arrangement 102 according to another embodiment of the invention. The LED light source filament arrangement 102 is similar to the LED light source filament arrangement 101 of Fig. 3 but differs therefrom in virtue of the following feature.

The phosphor 13 is configured to only partially convert second LED light source light emitted by the second plurality of LED light sources 5 into red light 6. Thus, at least some of the second plurality of LED light sources 5 need in this embodiment not necessarily emit red light directly, i.e. be red LED light sources. Therefore, the second plurality of LED light sources 5 of the LED light source filament arrangement 102 in total emit second LED light source light being a combination of red light 6 and unconverted light 14.

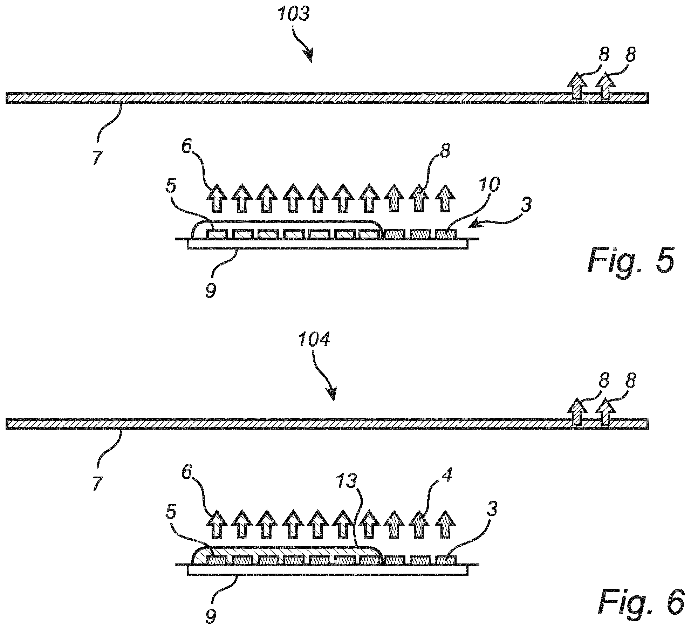

Fig. 5 shows a cross sectional side view of a LED light source filament arrangement 103 according to another embodiment of the invention. The LED light source filament arrangement 103 differs from that of Fig. 1 described above in virtue of the following features.

The first plurality of LED light sources 3 and the second plurality of LED light sources 5 are arranged on the same substrate 9. More particularly, the first plurality of LED light sources 3 are arranged on an end section of the substrate 9 and the second plurality of LED light sources 5 are arranged on the remaining part of the substrate 9.

Only the second plurality of LED light sources 5 are enclosed by an envelope. The phosphor 10 is applied on a surface of the solid state light sources of the first plurality of LED light sources 3.

Fig. 6 shows a cross sectional side view of a LED light source filament arrangement 104 according to another embodiment of the invention. The LED light source filament arrangement 104 is similar to the LED light source filament arrangement 103 of Fig. 5 but differs therefrom in virtue of the following feature.

The phosphor 13 is configured to convert second LED light source light emitted by the second plurality of LED light sources 5 into red light 6. Thus, the second plurality of LED light sources 5 need in this embodiment not necessarily emit red light directly, i.e. be red LED light sources.

Furthermore, the phosphor 13 is applied to the second plurality of LED light sources 5. Also, in the embodiment shown on Fig. 6 there is not applied any phosphor 10 to the first plurality of LED light sources 3. In other embodiments there may, however, be applied both a phosphor 10 to the first plurality of LED light sources 3 and a phosphor 13 to the second plurality of LED light sources 5. The phosphor 13 may be provided in a distance from the second plurality of LED light sources 5. The distance may be more than 1 mm. The phosphor 13 may be provided in or as part of the luminescent layer 7, or as a coating on the luminescent layer 7. Alternatively, or additionally, the phosphor 13 may be provided as a coating applied directly on the LED light sources of the second plurality of LED light sources 5 or on a surface of an envelope enclosing the second plurality of LED light sources 5.

Generally, and irrespective of the embodiment the first plurality of LED light sources 3 and the second plurality of LED light sources 5 may be arranged in various geometrical patterns with respect to each other, depending on which filament appearance is desired.

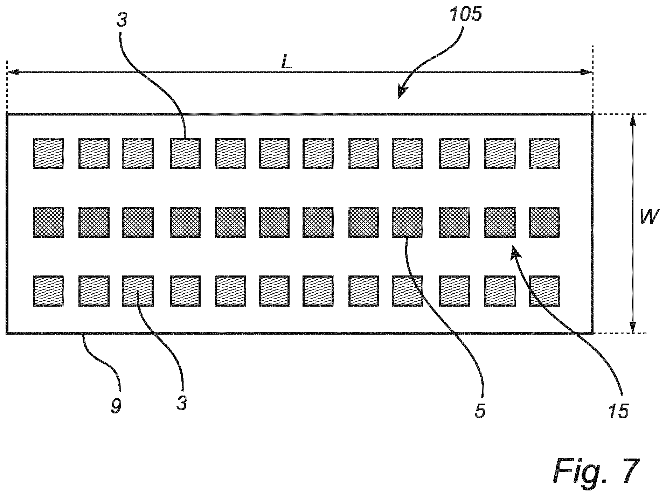

In one example of a LED light source arrangement 105 according to the invention, as shown in Fig. 7, the second plurality of LED light sources 5 may be arranged on a straight line, and the first plurality of LED light sources 3 may be distributed around the line formed by the second plurality of LED light sources 5. The straight line may be continuous line.

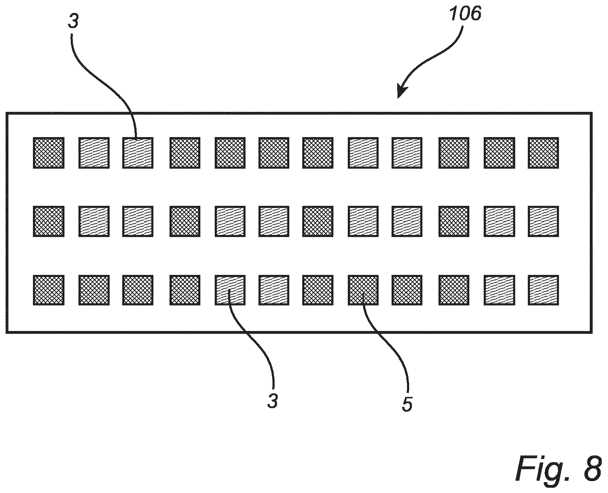

In another example of a LED light source arrangement according to the invention, the second plurality of LED light sources 5 may be arranged on a non-straight line, and the first plurality of LED light sources 3 may be distributed around the non-straight line formed by the second plurality of LED light sources 5. The non-straight line may be continuous line. Non limiting examples of a non-straight line includes a curving line - cf. e.g. the LED light source arrangement 106 shown in Fig. 8 -, a meandering line, a twisted line or a spiralling line.

Fig. 9 shows the LED light source filament arrangement according to Fig. 8 as it will be perceived by a viewer when it is in an off-state, while Fig. 10 shows the LED light source filament arrangement according to Fig. 8 as it will be perceived by a viewer when it is in an on-state. In the off-state, being a state in which the LED light sources are turned off, the luminescent element 7 will be visible to the viewer as shown in Fig. 9. In the on-state, being a state in which the LED light sources are turned on, the line of red LEDs will be visible to the viewer, while the blue LEDs will, due to conversion by the luminescent layer 7 not be visible to the viewer as shown in Fig. 10.

In yet another example, the first plurality of LED light sources 3 may be arranged in a matrix distributed around the second plurality of LED light sources 5.

Fig. 14 shows an exemplary lamp 20 comprising a LED light source filament arrangement 1 according to any embodiment of the invention. In the embodiment shown, the LED light source filament arrangement 1 is a linear shaped LED light source filament arrangement 1 and is arranged extending substantially as a filament of the lamp. The LED light source filament arrangement 1 of such a lamp may in other embodiments comprise other shapes, such as, but not limited to, spiral-shaped, helix-shaped, meandering, twisted and flat.

The lamp 20 further comprises a controller 21 configured for individually controlling at least the first plurality of LED light sources 3 and the second plurality of LED light sources 5 of the LED light source filament arrangement 1. The controller 21 is configured for controlling at least one of the CCT of the LED filament light and the CRI of the LED filament light. The controller 21 may also be configured for controlling other parameters related to the LED light sources and the LED filament light.

The lamp 20 further comprises an envelope 22 at least partially enveloping the at least one LED light source filament arrangement 1. The lamp 20 further comprises a cap 23. As shown on Fig. 14, the controller 21 is arranged within the envelope 22. When comprising a cap 23, the controller 21 may also be arranged inside the cap 23 such that it is hidden from view. The lamp 20 further comprises threading 24 for connection to a socket and a terminal 25 for connection to a source of electrical energy.

The person skilled in the art realizes that the present invention by no means is limited to the preferred embodiments described above. On the contrary, many modifications and variations are possible within the scope of the appended claims.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage.

## Claims

1. A light emitting diode, LED, filament arrangement (1) configured to, in operation, emit LED filament light (2), the LED filament arrangement comprising:
a first plurality of LED light sources (3) configured to, in operation, emit first LED light source light (4), the first LED light source light comprising blue LED light source light,
a second plurality of LED light sources (5) configured to, in operation, emit second LED light source light (6) the second LED light source light comprising red LED light source light, and
a luminescent layer (7) covering at least a part of the first plurality of LED light sources and at least a part of the second plurality of LED light sources, wherein
the luminescent layer (7) is configured to convert at least 88% of the blue LED light source light into converted light (8), the converted light being one or more of green and yellow light, and wherein
the second plurality of LED light sources (5) are arranged in a successional configuration without any LED light sources configured to, in operation, emit LED light source light of other colors than red being provided in the succession of the LED light sources of the second plurality of LED light sources (5), and
wherein the second plurality of LED light sources (5) further comprises a plurality of LED light sources configured to, in operation, emit blue LED light source light, whereby the second LED light source light further comprises blue LED light source light, the said plurality of LED light sources configured to, in operation, emit red LED light source light being covered by a second phosphor converting the blue LED light source light into red LED light source light.

2. A LED filament arrangement according to claim 1, wherein the LED filament light comprises 3%-7% blue LED light source light.

3. A LED filament arrangement according to claim 1 or 2, wherein the first plurality of LED light sources (3) and the second plurality of LED light sources (5) are arranged on the same carrier (9).

4. A LED filament arrangement according to any one of the above claims, wherein the luminescent layer (7) is provided in a distance (D) from the first plurality of LED light sources (3) and the second plurality of LED light sources (5), and wherein the distance (D) is more than 5 mm.

5. A LED filament arrangement according to any one of the above claims, wherein a pitch (P2) of the second plurality of LED light sources (5) is smaller than a pitch (P1) of the first plurality of LED light sources (3), and wherein P2 ≤ 0.5*P1.

6. A LED filament arrangement according to any one of the above claims, wherein the LED filament light (2) comprises a correlated color temperature (CCT) being smaller than 2500 K and a color rendering index (CRI) being larger than 80.

7. A LED filament arrangement according to any one of the above claims, wherein the luminescent layer (7) is configured to convert less than 5%, less than 3 %, less than 2 %, less than 1 % or 0 % of the red LED light source light into converted light (8).

8. A LED filament arrangement according to any one of the above claims, wherein the second plurality of LED light sources (5) are arranged on a line (15), and wherein the first plurality of LED light sources (3) are distributed around said line.

9. A LED filament arrangement according to claim 8, wherein at least one of the following applies: the line is a continuous line, and the line is arranged in a meandering or spiral pattern (16).

10. A LED filament arrangement according to any one of the above claims, wherein the first plurality of LED light sources (3) are arranged in a matrix.

11. A LED filament arrangement according to any one of the above claims, wherein the carrier (9) comprises a length L and a width W, wherein 0.5 < L/W < 2.

12. A LED filament arrangement according to any one of the above claims, wherein the LED filament arrangement comprises a light exit window (11) from which the LED filament light is emitted, and wherein the second plurality of LED light sources (5) are arranged closer to the light exit window than the first plurality of LED light sources (3).

13. A LED filament arrangement according to any one of the above claims, and further comprising a controller (12; 21) for individually controlling the first plurality of LED light sources and the second plurality of LED light sources, the controller being configured to change the correlated color temperature of said LED filament light from a first correlated color temperature (CCT1) to a second correlated color temperature (CCT2), wherein ICCT1 - CCT21 ≥ 300K.

14. A lamp or a luminaire (20) comprising a LED filament arrangement according to any one of the above claims.

## Patentansprüche

1. Leuchtdiodenfilamentanordnung, LED-Filamentanordnung, (1), die konfiguriert ist, um, in einem Betrieb, LED-Filamentlicht (2) zu emittieren, die LED-Filamentanordnung umfassend:
eine erste Vielzahl von LED-Lichtquellen (3), die konfiguriert sind, um, in einem Betrieb, erstes LED-Lichtquellenlicht (4) zu emittieren, das erste LED-Lichtquellenlicht umfassend blaues LED-Lichtquellenlicht,
eine zweite Vielzahl von LED-Lichtquellen (5), die konfiguriert sind, um, in einem Betrieb, zweites LED-Lichtquellenlicht (6) zu emittieren, das zweite LED-Lichtquellenlicht umfassend rotes LED-Lichtquellenlicht, und
eine lumineszierende Schicht (7), die mindestens einen Teil der ersten Vielzahl von LED-Lichtquellen und mindestens einen Teil der zweiten Vielzahl von LED-Lichtquellen bedeckt, wobei
die lumineszierende Schicht (7) konfiguriert, um mindestens 88 % des blauen LED-Lichtquellenlichts in konvertiertes Licht (8) umzuwandeln, wobei das konvertierte Licht eines oder mehrere von einem grünen und einem gelben Licht ist, und wobei
die zweite Vielzahl von LED-Lichtquellen (5) in einer aufeinanderfolgenden Konfiguration ohne beliebige LED-Lichtquellen angeordnet sind, die, in einem Betrieb, konfiguriert sind, um Lichtquellenlicht von anderen Farben als rot zu emittieren, das in der Abfolge der LED-Lichtquellen der zweiten Vielzahl von LED-Lichtquellen (5) bereitgestellt wird, und
wobei die zweite Vielzahl von LED-Lichtquellen (5) ferner eine Vielzahl von LED-Lichtquellen umfasst, die, in einem Betrieb, konfiguriert sind, um blaues LED-Lichtquellenlicht zu emittieren, wobei das zweite LED-Lichtquellenlicht ferner blaues LED-Lichtquellenlicht umfasst, wobei die Vielzahl von LED-Lichtquellen, die, in einem Betrieb, konfiguriert sind, um rotes LED-Lichtquellenlicht zu emittieren, durch einen zweiten Leuchtstoff bedeckt sind, der das blaue LED-Lichtquellenlicht in rotes LED-Lichtquellenlicht umwandelt.

2. LED-Filamentanordnung nach Anspruch 1, wobei das LED-Filamentlicht 3 %-7 % blaues LED-Lichtquellenlicht umfasst.

3. LED-Filamentanordnung nach Anspruch 1 oder 2, wobei die erste Vielzahl von LED-Lichtquellen (3) und die zweite Vielzahl von LED-Lichtquellen (5) auf demselben Träger (9) angeordnet sind.

4. LED-Filamentanordnung nach einem der vorstehenden Ansprüche, wobei die lumineszierende Schicht (7) in einer Distanz (D) von der ersten Vielzahl von LED-Lichtquellen (3) und der zweiten Vielzahl von LED-Lichtquellen (5) bereitgestellt ist und wobei die Distanz (D) mehr als 5 mm beträgt.

5. LED-Filamentanordnung nach einem der vorstehenden Ansprüche, wobei ein Abstand (P2) der zweiten Vielzahl von LED-Lichtquellen (5) kleiner als ein Abstand (P1) der ersten Vielzahl von LED-Lichtquellen (3) ist und wobei P2 ≤ 0,5*P1.

6. LED-Filamentanordnung nach einem der vorstehenden Ansprüche, wobei das LED-Filamentlicht (2) eine korrelierte Farbtemperatur (CCT), die kleiner als 2500 K ist, und einen Farbwiedergabeindex (CRI) umfasst, der größer als 80 ist.

7. LED-Filamentanordnung nach einem der vorstehenden Ansprüche, wobei die lumineszierende Schicht (7) konfiguriert ist, um weniger als 5 %, weniger als 3 %, weniger als 2 %, weniger als 1 % oder 0 % des roten LED-Lichtquellenlichts in konvertiertes Licht (8) umzuwandeln.

8. LED-Filamentanordnung nach einem der vorstehenden Ansprüche, wobei die zweite Vielzahl von LED-Lichtquellen (5) auf einer Linie (15) angeordnet sind und wobei die erste Vielzahl von LED-Lichtquellen (3) um die Linie herum verteilt sind.

9. LED-Filamentanordnung nach Anspruch 8, wobei mindestens eines der folgenden zutrifft: die Linie ist eine durchgehende Linie und die Linie ist in einem mäanderförmigen oder spiralförmigen Muster (16) angeordnet.

10. LED-Filamentanordnung nach einem der vorstehenden Ansprüche, wobei die erste Vielzahl von LED-Lichtquellen (3) in einer Matrix angeordnet sind.

11. LED-Filamentanordnung nach einem der vorstehenden Ansprüche, wobei der Träger (9) eine Länge L und eine Breite W aufweist, wobei 0,5 < L/W < 2.

12. LED-Filamentanordnung nach einem der vorstehenden Ansprüche, wobei die LED-Filamentanordnung ein Lichtaustrittsfenster (11) umfasst, aus dem das LED-Filamentlicht emittiert wird, und wobei die zweite Vielzahl von LED-Lichtquellen (5) näher am Lichtaustrittsfenster als die erste Vielzahl von LED-Lichtquellen (3) angeordnet ist.

13. LED-Filamentanordnung nach einem der vorstehenden Ansprüche, und ferner umfassend eine Steuerung (12; 21) zum individuellen Steuern der ersten Vielzahl von LED-Lichtquellen und der zweiten Vielzahl von LED-Lichtquellen, wobei die Steuerung konfiguriert ist, um die korrelierte Farbtemperatur des LED-Filamentlichts von einer ersten korrelierten Farbtemperatur (CCT1) auf eine zweite korrelierte Farbtemperatur (CCT2) zu ändern, wobei |CCT1 - CCT2| ≥ 300K.

14. Lampe oder Leuchte (20), umfassend eine LED-Filamentanordnung nach einem der vorstehenden Ansprüche.

## Revendications

1. Agencement de filament à diode électroluminescente, **DEL** (1) conçu pour, en fonctionnement, émettre une lumière à filament à **DEL** (2), l'agencement de filament à **DEL** comprenant :
une première pluralité de sources de lumière à **DEL** (3) conçues pour émettre, en fonctionnement, une lumière de première source de lumière **à DEL** (4), la lumière de première source de lumière à **DEL** comprenant une lumière de source de lumière à **DEL** bleue,
une seconde pluralité de sources de lumière à **DEL** (5) conçues pour émettre, en fonctionnement, une lumière de seconde source de lumière **à DEL** (6), la lumière de seconde source de lumière à **DEL** comprenant une lumière de source de lumière à **DEL** rouge, et
une couche luminescente (7) recouvrant au moins une partie de la première pluralité de sources de lumière à **DEL** et au moins une partie de la seconde pluralité de sources de lumière à **DEL,** dans lequel
la couche luminescente (7) est conçue pour convertir au moins 88 % de la lumière de source de lumière à **DEL** bleue en lumière convertie (8), la lumière convertie étant une ou plusieurs d'une lumière verte et jaune, et dans lequel
la seconde pluralité de sources de lumière à **DEL** (5) sont agencées dans une configuration de succession sans qu'aucune source de lumière à **DEL** quelconque conçue pour émettre, en fonctionnement, une lumière de source de lumière à **DEL** d'autres couleurs que le rouge ne soit fournie dans la succession des sources de lumière à **DEL** de la seconde pluralité de sources de lumière à **DEL** (5), et
dans lequel la seconde pluralité de sources de lumière à **DEL** (5) comprend en outre une pluralité de sources de lumière à **DEL** conçues pour émettre, en fonctionnement, de la lumière de source de lumière à **DEL** bleue, moyennant quoi la lumière de seconde source de lumière à **DEL** comprend en outre de la lumière de source de lumière à **DEL** bleue, ladite pluralité de sources de lumière à **DEL** conçues pour émettre, en fonctionnement, de la lumière de source de lumière à DEL rouge étant couverte par un second luminophore convertissant la lumière de source de lumière à DEL bleue en lumière de source de lumière à DEL rouge.

2. Agencement de filament à DEL selon la revendication 1, dans lequel la lumière de filament à DEL comprend 3 % à 7 % de lumière de source de lumière à DEL bleue.

3. Agencement de filament à DEL selon la revendication 1 ou 2, dans lequel la première pluralité de sources de lumière à DEL (3) et la seconde pluralité de sources de lumière à DEL (5) sont agencées sur le même support (9).

4. Agencement de filament à DEL selon l'une quelconque des revendications précédentes, dans lequel la couche luminescente (7) est fournie à une distance (D) de la première pluralité de sources de lumière à DEL (3) et de la seconde pluralité de sources de lumière à DEL (5), et dans lequel la distance (D) est supérieure à 5 mm.

5. Agencement de filament à DEL selon l'une quelconque des revendications précédentes, dans lequel un pas (P2) de la seconde pluralité de sources de lumière à DEL (5) est plus petit qu'un pas (P1) de la première pluralité de sources de lumière à DEL (3), et dans lequel P2 ≤ 0,5*P1.

6. Agencement de filament à DEL selon l'une quelconque des revendications précédentes, dans lequel le filament à DEL (2) comprend une température de couleur corrélée (CCT) inférieure à 2500 K et un indice de rendu des couleurs (CRI) supérieur à 80.

7. Agencement de filament à DEL selon l'une quelconque des revendications précédentes, dans lequel la couche luminescente (7) est conçue pour convertir moins de 5 %, moins de 3 %, moins de 2 %, moins de 1 % ou 0 % de la lumière de source de lumière à DEL rouge en lumière convertie (8).

8. Agencement de filament à DEL selon l'une quelconque des revendications précédentes, dans lequel la seconde pluralité de sources de lumière à DEL (5) sont agencées sur une ligne (15), et dans lequel la première pluralité de sources de lumière à DEL (3) sont distribuées autour de ladite ligne.

9. Agencement de filament à DEL selon la revendication 8, dans lequel au moins l'un des éléments suivants s'applique : la ligne est une ligne continue, et la ligne est agencée en un motif de méandres ou de spirale (16).

10. Agencement de filament à DEL selon l'une quelconque des revendications précédentes, dans lequel la première pluralité de sources de lumière à DEL (3) sont agencées en une matrice.

11. Agencement de filament à DEL selon l'une quelconque des revendications précédentes, dans lequel le support (9) comprend une longueur L et une largeur W, dans lequel 0,5 < L/W < 2.

12. Agencement de filament à DEL selon l'une quelconque des revendications précédentes, dans lequel l'agencement de filament à DEL comprend une fenêtre de sortie de lumière (11) à partir de laquelle la lumière de filament à DEL est émise, et dans lequel la seconde pluralité de sources de lumière à DEL (5) sont agencées plus près de la fenêtre de sortie de lumière que la première pluralité de sources de lumière à DEL (3).

13. Agencement de filament à DEL selon l'une quelconque des revendications précédentes, et comprenant en outre un dispositif de commande (12 ; 21) pour commander individuellement la première pluralité de sources de lumière à DEL et la seconde pluralité de sources de lumière à DEL, le dispositif de commande étant conçu pour modifier la température de couleur corrélée de ladite lumière de filament à DEL d'une première température de couleur corrélée (CCT1) à une seconde température de couleur corrélée (CCT2), dans lequel ICCT1 - CCT2| ≥ 300K.

14. Lampe ou luminaire (20) comprenant un agencement de filament à DEL selon l'une quelconque des revendications précédentes.
